# EUROPEAN PATENT APPLICATION

(11) **EP 0 932 197 A1**
(43) Date of publication of application: **28.07.1999**
(21) Application number: 98306767.9
(22) Date of filing: 24.08.1998
(51) Int. Cl.: H01L 21/8234, H01L 21/8238

(54) **Method of varying MOS transistor electrical characteristics of integrated circuits**

(30) Priority: 27.01.1998 US 13766
(71) Applicant: LSI LOGIC CORPORATION, Milpitas, CA 95035 (US)
(72) Inventor: Schinella, Richard D., Saratoga, California 95070 (US)
(74) Representative: Hallam, Arnold Vincent

(57) **Abstract**

An integrated circuit (8) and method of fabricating lightly doped source/drain type devices thereon to form spacer widths of different dimensions to effectively vary the electrical characteristics of selected ones of the devices to facilitate different drive-current capabilities on the same chip. By varying the spacer width the lateral separation between the lightly doped portion of the source and drain regions (14,16) and the heavily doped portions of the source and drain regions (14,16) can be varied in a controlled manner, giving rise to a variation in device performance characteristics.

## Description

### Technical Field

This invention relates in general to methods of fabricating silicon-based integrated circuits, and the invention more particularly relates to a method of fabricating a lightly doped source/drain type device for spacer widths of different dimensions to effectively vary the electrical characteristics of selected ones of the devices on a common integrated circuit chip to facilitate different drive-current capabilities on the same chip.

### Background Art

The fabrication techniques for producing lightly doped source/drain type silicon-based integrated circuit devices have been practiced for many years. For example reference may be made to the following technical documents which are incorporated by reference into the present disclosure: H.B.Bakalu, *Circuits, Interconnections, and packaging for VLSI*, Addison-Wesley (1990); A.S. Grove, *Physics and Technology of Semiconductor Devices*, Wiley, New York, NY, (1967); R.S. Muller and T.I. Kamins, *Device Electronics for Integrated Circuits*, Wiley, New York, NY, (1977); E.S. Yang, *Fundamentals of Semiconductor Devices*, McGraw-Hill, New York, NY (1978); B.G. Streetman, *Solid State Electronic Devices*, Prentice-Hall, Englewood Cliffs, NJ (1980); T.E. Dillinger, *VLSI Engineering*, Prentice-Hall, Englewood Cliffs, NJ (1988); S.M. Sze, *Physics of Semiconductor Devices*, 2d ed., Wiley, New York, (1981); R.H. Krambeck, C.M. Lee, and H.S. Law, "High-speed compact circuit with CMOS," *IEEE Journal of Solid-State Circuits*, vol. SC-17, pp 614-619, June 1982; and Texas Instruments VLSI Laboratory, "Technology and design challenges of MOS VLSI," *IEEE Journal of Solid-State Circuits*, vol. SC-17, no. 3, pp 442-448, June 1982.

While such manufacturing techniques as disclosed in the above reference documents have been satisfactory for many applications, it would be highly desirable to have a new and improved manufacturing method that produces integrated circuits that meet the higher performance speed demands in today's technology.

More particularly, the technological demands of today require higher performance speeds with lower chip power dissipation coupled with the ability to mix p-channel and n-channel MOS devices with varying drive current capabilities.

Heretofore, providing such devices with varying drive current capabilities has not been practical.

Therefore it would be highly desirable to have a new and improved manufacturing technique for producing different types and kinds of LDD MOS transistor devices on a common substrate having different drive current and leakage current capabilities.

### Disclosure of Invention

Therefore the principal object of the present invention is to provide a new and improved fabrication method for producing LDD MOS transistor devices having different drive current and leakage current capabilities on the same integrated circuit chip.

Briefly, the above and further objects of the present invention are realized by providing a new and improved method of fabricating a lightly doped source/drain type integrated circuit device resulting in both drive and leakage current variations. The method includes a two step spacer etch process wherein a first etch step is performed to produce a wide sidewall spacer. Several of the sidewall spacers are then protectively masked to effectively prevent them from being further etched during a second or final spacer etching step. By appropriate placement of the mask or by covering selected ones of the p-channel or n-channel transistor devices with photoresist, the formation of spacers of desired heights and widths is accomplished during the second etching step. Such variations in spacers sizes results in the formation of different types and kinds of LDD MOS devices on the same substrate with different drive current and leakage current capabilities.

In one embodiment the sidewall spacers are made narrow resulting in a device providing higher drive currents, higher hot carrier sensitivity, and higher performance speed via reduced device gate delays.

In another embodiment, the sidewall spacer is made wide resulting in a device having lower drive currents, lower device S/D leakage currents, lower hot carrier sensitivity, and lower speed via increased device gate delays.

### Brief Description of Drawings

The above-mentioned and other objects and features of this invention and the manner of attaining them will become apparent, and the invention itself will be best understood by reference to the following description of the embodiments of the invention taken in conjunction with the accompanying drawings, wherein:
FIG. 1 is a fragmentary cross sectional view of a low drive, low leakage LDD MOS transistor device which is constructed in accordance with the present invention;
FIG. 2 is a fragmentary cross-sectional view of a high drive, high leakage LDD MOS transistor device which is constructed in accordance with the present invention;
FIG. 3 is a fragmentary cross section view of a circuit die utilized in the fabrication of an integrated circuit chip having a plurality of different types of LDD MOS transistor devices, illustrating the die immediately prior to a first spacer etching stage of manufacture;
FIG. 4 is a fragmentary cross section view of the circuit die of FIG. 3, illustrating the die immediately after the first spacer etching stage of manufacture;
FIG. 5 is a fragmentary cross section view of the circuit die of FIG. 4, illustrating the die at a masking stage of manufacture; and
FIG. 6 is a fragmentary cross section view of the circuit die of FIG. 5, illustrating the die after a second spacer etching stage of manufacture.

### Best Mode For Carrying Out The Invention

Referring now to the drawings, and more particularly to FIG. 6 thereof, there is shown an integrated circuit chip 8, having a plurality of different types of lightly doped source/drain type devices with different types of drive current capabilities, which integrated circuit chip 8 is constructed in accordance with the present invention. The integrated circuit chip 8 having different types and kinds of LDD MOS devices formed thereon is fabricated in accordance with the novel method of the present invention.

The integrated circuit chip 8 generally comprises a semiconductor substrate 9 having formed thereon a plurality of n wells and p wells, such as n wells 70 and 71 and p wells 72 and 73, to facilitate the formation of at least one low drive, low leakage, lightly doped source/drain (LDD), metal oxide semiconductor (MOS) transistor device 10, and at least one high drive, high leakage, lightly doped source/drain (LDD), metal oxide semiconductor (MOS) transistor device 11.

As best seen in FIG. 6, The MOS device 10 generally includes a source region 14, a drain region 16, a LDD region 18 adjacent to the source region 14, and another LDD region 20 adjacent to the drain region 16. The LDD regions 18 and 20 define a channel 22 therebetween over which is formed a gate 24, having a gate oxide layer 25 disposed adjacent to the channel 22. An oxide or dielectric spacer 26 isolates the gate 24 from the LDD region 18 and another oxide or dielectric spacer 28 isolates the gate 24 from the other LDD region 20.

As best seen in FIG. 6, the MOS device 11 generally includes a source region 34, a drain region 36, a LDD region 38 adjacent to the source region 34, and another LDD region 40 adjacent to the drain region 36. The LDD regions 38 and 40 define a channel 42 therebetween over which is formed a gate 44 having a gate oxide layer 45 adjacent to the channel 42. An oxide or dielectric spacer 46 isolates the gate 44 from the LDD region 38 and another oxide or dielectric spacer 48 isolates the gate 44 from the other LDD region 40.

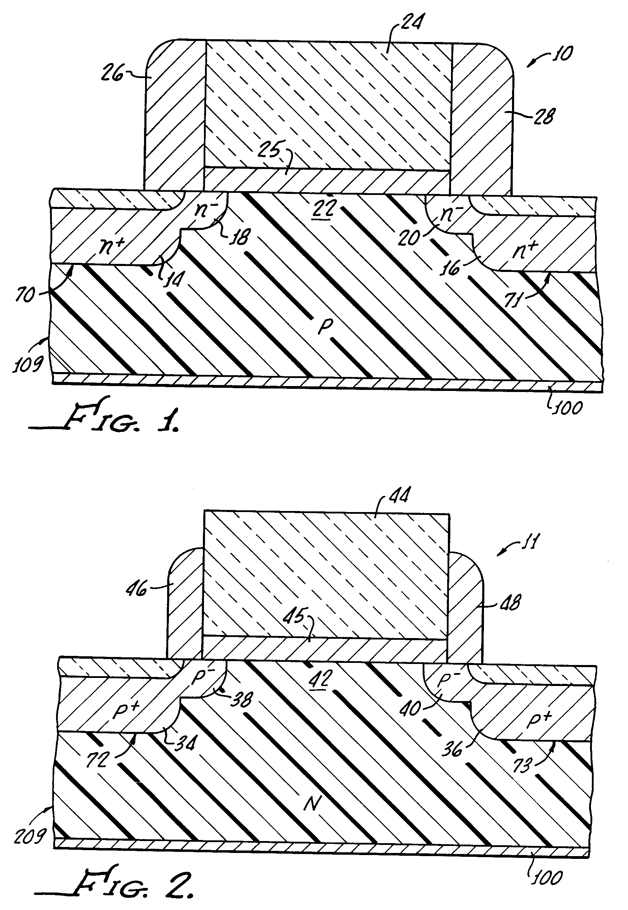

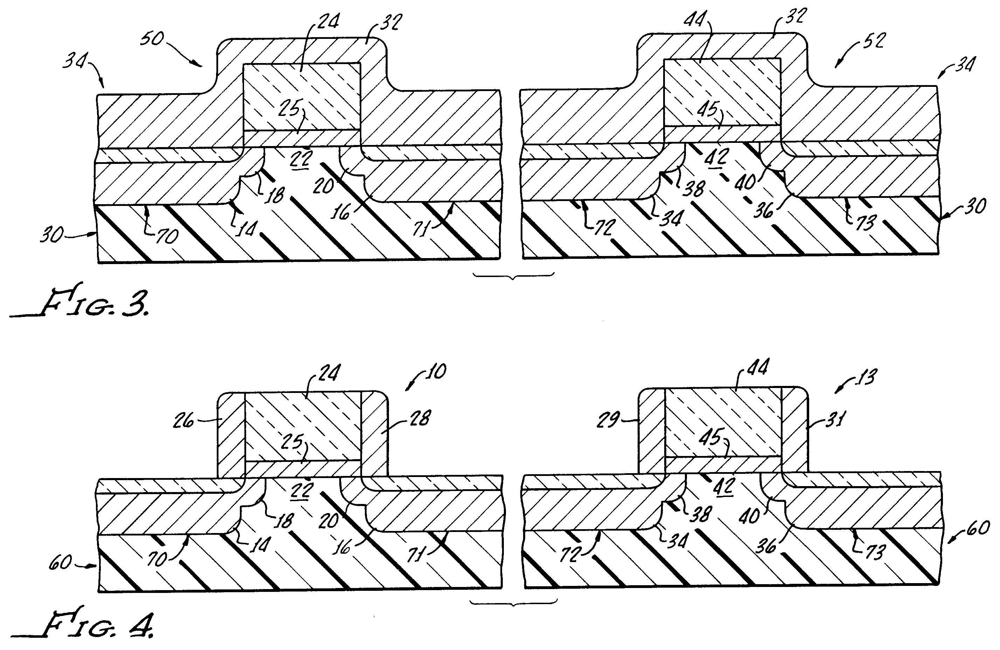

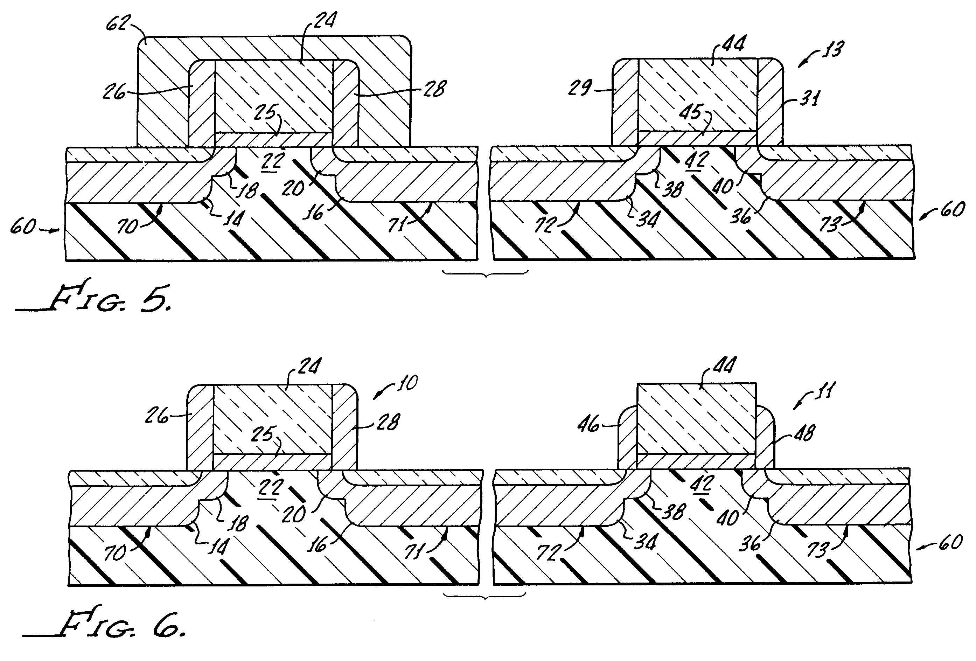

In order to fabricate the integrated circuit chip 8, a prefabricated semiconductor die 30 (FIG. 3) having a plurality of LDD MOS devices formed thereon, such as an LDD MOS transistor device 50 and an LDD MOS transistor die 52, is processed by overlying the LDD MOS devices with a dielectric layer of insulative material 32, such as a silicon dioxide layer, to form a modified die 34 which can be further processed to have a set of sidewall spacers of a desired height and thickness as will be explained hereinafter in greater detail.

As the method of forming the prefabricated LLD MOS transistor die 30 is conventional and well known to those skilled in the art, the method of fabricating the die 30 will not be described hereinafter in greater detail except to mention that the LDD regions 18, 20, 38, and 40 respectively are formed by means of low energy dose implantation, while the source and drain regions 14, 16, 34, and 36 respectively are formed by high energy implantation.

After the layer of insulative material 32 is formed , the modified die 34 is etched to form an integrated circuit chip 60 (FIG. 4 ) having a plurality of nMOS and pMOS devices, such as the nMOS device 10 and the pMOS device 13 each having a set of substantially uniform wide wall LDD spacers, such as the spacers 26, 28 and 29,31 respectively. The resulting wide wall spacers function as electrical isolators to help prevent undesired and unwanted shorts between the gate and source/drain of each of the resulting semiconductor devices..

Although in the preferred embodiment of the present invention the removal of the insulative layer 32 was described as being accomplished with an etching technique, those skilled in the art will understand that other techniques can be employed, such as ion milling or sputtering techniques. Also those skilled in the art will understand that the LDD spacers can be formed of any other suitable insulating material which is compatible with silicon device processing, such as silicon nitride.

As best seen in FIG. 5, in order to facilitate the formation of different sized spacers on the same substrate, a mask or a layer of photoresist 62 is then applied over that portion of the die 60 that is to be dedicated to low drive, low leakage type devices. The other portion of the die 60 that is to be dedicated to high drive, high leakage type devices is not covered with the photoresist layer 62.

The masked semiconductor die 60 is then etched so that spacers, such as the spacers 46 and 48, are formed having substantially shorter and narrower dimensions than the previously formed and masked spacers 26 and 28. For this second spacer etch operation, isotropic etches may be employed to provide lateral etching. Isotropic etches can be dry etch (plasma) or wet etch. The resulting integrated circuit chip 8, having a plurality of low drive current, low leakage current devices 10 and a plurality of high drive current, high leakage current devices 11 formed thereon may then be cut to provide wafers mountable on a printed circuit board 100, such as a wafer 109 with a plurality of only low drive devices10 illustrated in FIG. 1, a wafer 209 with only high drive devices such as the device 11 illustrated in FIG. 2, or a wafer 8 with a combination of low drive devices 10 and high drive devices 11 as illustrated in FIG. 6.

Although in the preferred embodiment a nMOS type device 10 and a pMOS type device 11 were described, those skilled in the art will understand that the structure of the devices 10 and 11 could be reversed so that the device 10 would be a pMOS type device and the device 11 would be a nMOS type device. Therefore in the true spirit and scope of the present invention different modifications are possible and are contemplated. Both nMOS and pMOS devices with short and long channels are possible and contemplated, and may be combined with the concept of narrow and wide LDD spacers, described herein, to produce a multitude of devices with different operating characteristics. Furthermore, the printed circuit board concept may be extended to a multichip module or hybrid module.

## Claims

1. A method of making an integrated circuit having a plurality of n-channel and p-channel devices with different drive current capabilities comprising:
etching a silicon-based integrated circuit die having a pre-formed semiconductor structure having a plurality of n-channel and p-channel devices thereon to form a wide sidewall spacer;
masking the resulting spacer relative to selected ones of the n-channel and the p-channel devices; and
etching the masked silicon-based integrated circuit resulting from the first mentioned etching step to form spacers of desired sizes at certain ones of the n-channel devices and to form spacers of other desired sizes at certain ones of the p-channel devices to facilitate fabricating an integrated circuit having a plurality of n-channel and p-channel devices with substantially different drive current capabilities.

2. A method of making an integrated circuit having n-channel devices with different drive current capabilities comprising:
etching a silicon-based integrated circuit die having a pre-formed semiconductor structure having a plurality of n-channel devices thereon to form a wide sidewall spacer;
masking the resulting spacer relative to selected ones of the n-channel devices; and
etching the masked silicon-based integrated circuit resulting from the first mentioned etching step to form spacers of desired sizes at certain ones of the n-channel devices and to form spacers of other desired sizes at certain other ones of the n-channel devices to facilitate fabricating an integrated circuit having a plurality of n-channel devices with substantially different drive current capabilities.

3. A method of making an integrated circuit having p-channel devices with different drive current capabilities comprising:
etching a silicon-based integrated circuit die having a pre-formed semiconductor structure having a plurality of p-channel devices thereon to form a wide sidewall spacer;
masking the resulting spacer relative to selected ones of the p-channel devices; and
etching the masked silicon-based integrated circuit resulting from the first mentioned etching step to form spacers of desired sizes at certain ones of the p-channel devices and to form spacers of other desired sizes at certain other ones of the p-channel devices to facilitate fabricating an integrated circuit having a plurality of p-channel devices with substantially different drive current capabilities.

4. An integrated circuit having a plurality of n-channel and p-channel devices with different drive current capabilities made by the method of claim 1.

5. An integrated circuit having a plurality of n-channel devices with selected ones of the n-channel devices having different drive current capabilities than other selected ones of the n-channel devices made by the method of claim 2.

6. An integrated circuit having a plurality of p-channel devices with selected ones of the p-channel devices having different drive current capabilities than other selected ones of the n-channel devices made by the method of claim 3.

7. A printed circuit board having at least one integrated circuit having a plurality of n-channel and p-channel devices with different drive current capabilities made by the method of claim 1.

8. A printed circuit board having at least one integrated circuit having a plurality of n-channel devices with selected ones of the n-channel devices having different drive current capabilities than other selected ones of the n-channel devices made by the method of claim 2.

9. A printed circuit board having at least one integrated circuit having a plurality of p-channel devices with selected ones of the p-channel devices having different drive current capabilities than other selected ones of the n-channel devices made by the method of claim 3.

10. An electronic device having at least one printed circuit board with at least one integrated circuit thereon, said integrated circuit having a plurality of n-channel and p-channel devices with different drive current capabilities made by the method of claim 1.

11. An electronic device having at least one printed circuit board with at least one integrated circuit thereon, said integrated circuit having a plurality of n-channel devices with selected ones of the n-channel devices having different drive current capabilities than other selected ones of the n-channel devices made by the method of claim 2.

12. An electronic device having at least one printed circuit board with at least one integrated circuit thereon, said integrated circuit having a plurality of p-channel devices with selected ones of the p-channel devices having different drive current capabilities than other selected ones of the n-channel devices made by the method of claim 3.
